(19) **Europäisches Patentamt**
**European Patent Office**
**Office européen des brevets**

(11) **EP 4 358 325 A1**

(12) **EUROPEAN PATENT APPLICATION**

(43) Date of publication:
**24.04.2024 Bulletin 2024/17**

(21) Application number: **23198235.6**

(22) Date of filing: **19.09.2023**

(51) International Patent Classification (IPC):
***H01S 5/183*** (2006.01)     ***H01S 5/30*** (2006.01)
***H01S 5/20*** (2006.01)

(52) Cooperative Patent Classification (CPC):
**H01S 5/18358; H01S 5/18311; H01S 5/18319;**
**H01S 5/18355; H01S 5/3095;** H01S 5/18305;
H01S 5/2063

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **19.10.2022 US 202263417626 P**
**05.05.2023 US 202318312967**

(71) Applicant: **II-VI Delaware, Inc.**
**Wilmington, Delaware 19801 (US)**

(72) Inventors:
• **PISSIS, Antoine**
**Wilmington, 19801 (US)**
• **TIRELLI, Stefano**
**Wilmington, 19801 (US)**
• **ZIBIK, Evgeny**
**Wilmington, 19801 (US)**

(74) Representative: **Schmidt, Christian**
**ZSP Patentanwälte PartG mbB**
**Hansastraße 32**
**80686 München (DE)**

(54) **VCSEL POLARIZATION CONTROL WITH STRUCTURAL BIREFRINGENT CAVITY**

(57)     This disclosure describes a method of forming a VCSEL with a structural birefringent cavity. This method comprises growing a bottom distributed Bragg reflector (DBR) and a first part of a cavity on a substrate to form a bottom structure comprising a plurality of layers. One or more anisotropic features are etched on a upper layer of the bottom structure to produce a patterned growth interface. A remaining part of the cavity and a top DBR on the patterned growth interface are overgrown to form an epitaxial structure. One or more oxide apertures are formed in the epitaxial structure.

**EP 4 358 325 A1**

**Description**

BACKGROUND

Limitations and disadvantages of traditional vertical-cavity surface-emitting lasers will become apparent to one of skill in the art, through comparison of such approaches with some aspects of the present method and system set forth in the remainder of this disclosure with reference to the drawings.

BRIEF SUMMARY

Systems and methods are provided for producing vertical-cavity surface-emitting laser (VCSEL) with a birefringent cavity operable to control polarization, substantially as illustrated by and/or described in connection with at least one of the figures, as set forth more completely in the claims.

BRIEF DESCRIPTION OF THE DRAWINGS

FIG. 1 illustrates an example VCSEL epitaxial structure with a birefringent cavity, in accordance with various example implementations of this disclosure.

FIGs. 2A and 2B illustrate examples of cavities, in accordance with various example implementations of this disclosure.

FIG. 3A illustrates an example evolution of the effective refractive index with the grating fill factor, in accordance with various example implementations of this disclosure.

FIG. 3B illustrates an example evolution of the birefringence strength with the grating fill factor, in accordance with various example implementations of this disclosure.

FIG. 4A illustrates an example of an emission wavelength associated with the parallel polarization direction and an example of an emission wavelength associated with the perpendicular polarization direction, in accordance with various example implementations of this disclosure.

FIG. 4B illustrates an example of gain associated with emission wavelength of FIG. 4A, in accordance with various example implementations of this disclosure.

FIG. 5A illustrates an example of oxide aperture VCSEL with a patterned cavity where the oxide aperture is above the patterned growth interface, in accordance with various example implementations of this disclosure.

FIG. 5B illustrates an example of oxide aperture VCSEL with a patterned cavity where the oxide aperture is below the patterned growth interface, in accordance with various example implementations of this disclosure.

FIG. 6A illustrates an example of a combining patterned cavity with tunnel junction lithographic aperture with two separated etch and overgrowth steps, in accordance with various example implementations of this disclosure.

FIG. 6B illustrates an example of a combining patterned cavity with tunnel junction lithographic aperture with two successive etch steps and one overgrowth step, in accordance with various example implementations of this disclosure.

FIG. 7A illustrates an example of a combining patterned cavity with blocking lithographic aperture with two separated etch and overgrowth steps, in accordance with various example implementations of this disclosure.

FIG. 7B illustrates an example of a combining patterned cavity with blocking layer lithographic aperture with two successive etch steps and one overgrowth step, in accordance with various example implementations of this disclosure.

FIG. 8 illustrates an example aperture definition with implantation, in accordance with various example implementations of this disclosure.

FIG. 9 illustrates an example of power versus current and polarization characteristics, in accordance with various example implementations of this disclosure.

FIG. 10 illustrates an example evolution of the degree of linear polarization (DOLP) with the grating fill factor and grating refractive index contrast, in accordance with various example implementations of this disclosure.

FIG. 11 illustrates an example of optical power and polarization characteristics versus the operating current, in accordance with various example implementations of this disclosure.

DETAILED DESCRIPTION

A vertical-cavity surface-emitting laser (VCSEL) is a type of semiconductor laser diode with laser beam emission perpendicular from the top surface, contrary to conventional edge-emitting semiconductor lasers which emit from surfaces formed by cleaving the individual chip out of a wafer. VCSELs are used in various laser products, including computer mice, fiber optic communications, laser printers, Face ID, and smart glasses.

A polarization direction can be promoted in a laser when the associated threshold current is lower than the other polarization directions. Once the threshold gain for the desired polarization direction is reached, gain clamping prevents reaching the threshold gain of the undesired polarized directions and locks the polarization. Threshold gain level is controlled by the optical gain coefficient and the optical losses. Laser polarization control is achieved by inducing polarization dependent gain coefficient as a first and second mechanism and optical losses as a third mechanism. Such polarization dependent gain and optical losses are not present by default in VCSELs due to the surface emission and the circular geometry of the emitter. Therefore, as described in this disclosure, polarization dependent gain and optical losses may be induced to control the polarization of the VCSEL.

The present disclosure describes the control of polarization in a VCSEL by patterning anisotropic features in the cavity and performing overgrowth. The patterning introduces birefringence properties in the cavity structure. Birefringence is the optical property of a material having a refractive index that depends on the polarization and propagation direction of light. An anisotropic material is characterized by a physical property that has a different value when measured in different directions. Birefringent materials are optically anisotropic.

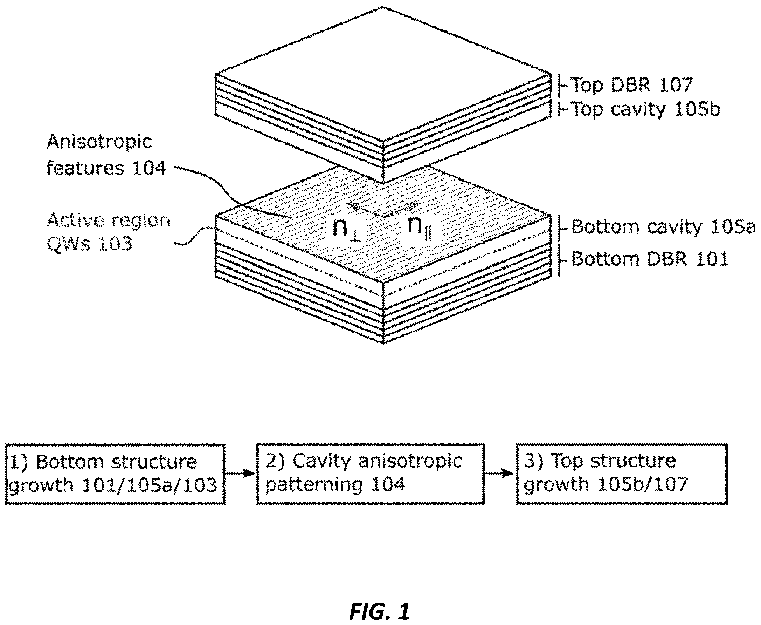

FIG. 1 illustrates an example VCSEL epitaxial structure with a birefringent cavity, in accordance with various example implementations of this disclosure.

The epitaxy structure, represented in FIG. 1, is formed as follows. Within a first growth, the bottom distributed Bragg reflector (DBR) 101 and the first part of the cavity 105 containing the active region quantum wells (QWs) 103 are grown on a substrate. Then, anisotropic features are defined via lithography and are shallowly etched using either dry or wet etching on the upper layer of the bottom structure. The interface between the bottom and the top is located in the cavity 105. The bottom structure comprises the bottom DBR 101, the active region QWs 103 and an upper layer of the bottom structure 105a. The top structure comprises a lower layer of the top structure 105b and the top DBR 107.

In the top emission configuration the top DBR 107 has lower reflectivity than the bottom DBR 101. In bottom emission configuration, the bottom DBR 101 has a lower reflectivity compared to the top DBR 107. In bottom emission configuration, the laser beam goes through the substrate.

An example of anisotropic features comprises linear gratings. The grating may also be 2D and containing anisotropic features: e.g. ovals/ellipses, rectangles, diamonds or circles/squares with different periods in orthogonal directions. Linear grating may be periodical, quasi periodical or random linear gratings.

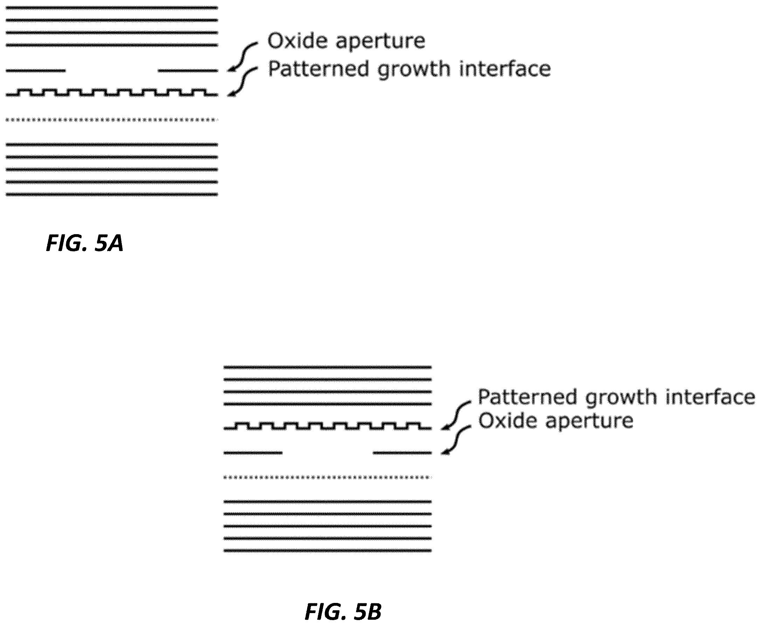

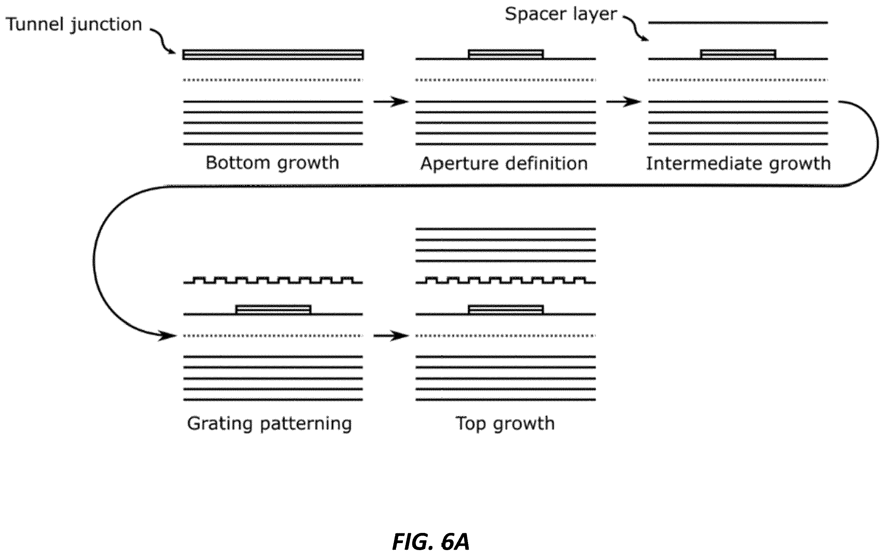

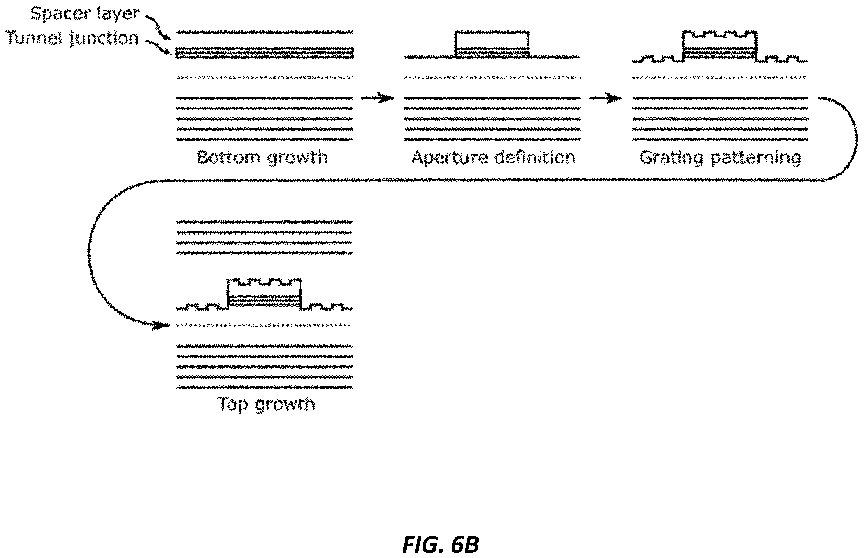

The remaining part of the cavity 105 and the top DBR 107 are overgrown and complete the cavity 105 (e.g., Fabry-Perot cavity) of the VCSEL. The resulting epitaxial structure can then undergo standard wafer processing to form the oxide aperture VCSEL emitters. Note that both front side and back side emission can be considered with this approach. Different configurations are also described below regarding FIGs. 5 and 6.

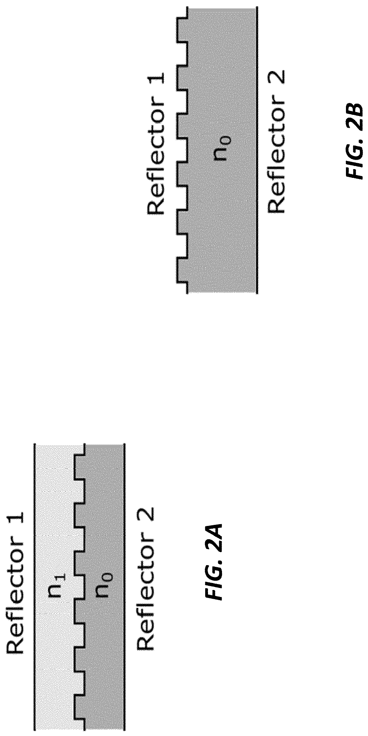

FIGs. 2A and 2B illustrate examples of cavities, in accordance with various example implementations of this disclosure.

In the first example configuration (FIG. 2A), the overgrown layer has a different material refractive index $n_1$ compared to the etched layer of the bottom structure $n_0$. Planar reflectors will result in the variation of the optical thickness of the cavity following the profile of the etched features.

In the second example configuration (FIG. 2B), the overgrowth layer shares the same refractive index as the etched layer of the bottom structure. If the overgrowth interface is close to one of the reflectors, the etched features get transferred to the reflector profile. Both configurations result in a variation of the cavity optical thickness following the etched profile. Due to the variation in the optical thickness of cavity, the local refractive index may be offset by $\Delta n$. As a result, the refractive index profile follows the etched features.

A anisotropic profile of the refractive index exhibits an equivalent effective refractive index which is anisotropic, i.e., birefringent. The refractive index parallel to the grating $n_\parallel$ (slow axis) is larger than the refractive index perpendicular to the grating $n_\perp$ (fast axis). The difference $(n_\parallel - n_\perp)$ between the refractive index of the slow axis and the refractive index of the fast axis is $\Delta n$. The ratio $(n_\parallel - n_\perp) / n_0$ defines the birefringence strength. The birefringence strength depends on the grating geometry and the grating refractive index contrast $\Delta n / n_0$.

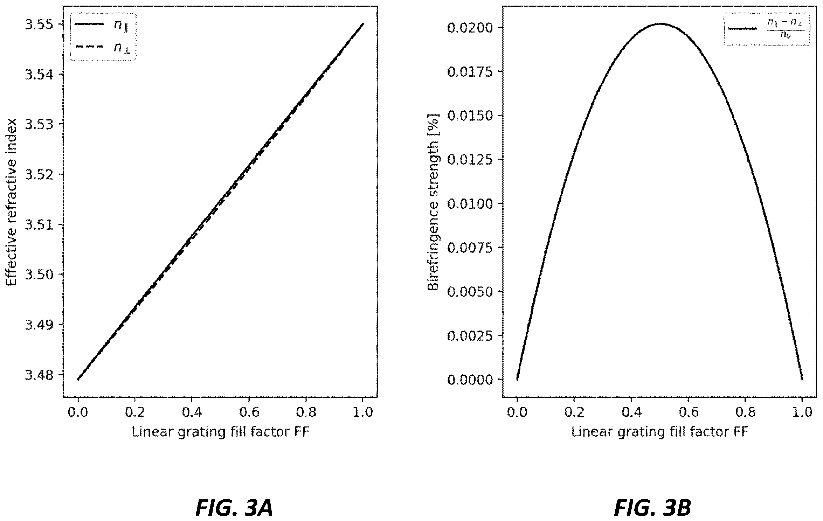

FIG. 3A illustrates an example evolution of the effective refractive index with the grating fill factor, in accordance with various example implementations of this disclosure.

FIG. 3B illustrates an example evolution of the birefringence strength with the grating fill factor, in accordance with various example implementations of this disclosure.

The fill factor (FF) is defined by the ratio of the grating ridge width and the grating period. For a grating refractive index contrast of 3% $(\Delta n / n_0)$, the birefringence is maximal for a fill factor around 0.5. The birefringence strength is estimated to be around 0.02% which is high enough considering the gain clamping mechanism.

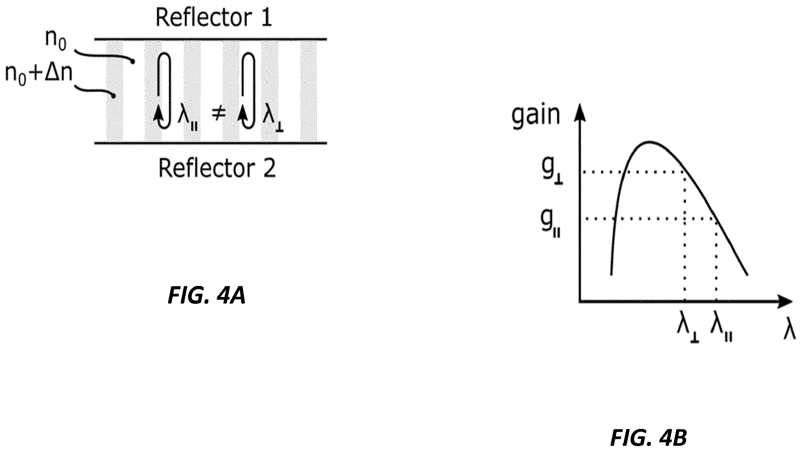

In a cavity with a birefringent medium, the polarizations parallel and perpendicular to slow axis propagate with different refractive indexes. FIG. 4A illustrates an example of an emission wavelength associated with the parallel polarization direction and an example of an emission wavelength associated with the perpendicular polarization direction, in accordance with various example implementations of this disclosure. Considering the cavity thickness is the same for both directions, the two directions are associated to two different emission wavelengths $\lambda_{\parallel}$ (slow axis) and $\lambda_{\perp}$ (fast axis) as illustrated in FIG. 4A. The optical thickness is the product of the refractive index with the physical thickness. The optical thickness sets the emission wavelength.

FIG. 4B illustrates an example of gain associated with emission wavelength, in accordance with various example implementations of this disclosure. Quantum wells (QWs) typically provide gain which varies with the wavelength. Combining polarization dependent emission wavelength and wavelength dependent gain results in polarization dependent gain as shown in FIG. 4B. The polarization direction associated with the highest gain coefficient is promoted. The promoted polarization direction with this first mechanism depends on the gain variation with the wavelength. For wavelengths larger than the wavelength at gain maximum, the gain decreases with the wavelength. Thus, the polarization along the fast axis (i.e., perpendicular to the grating direction) is promoted. Accordingly, in the first mechanism, polarization direction is selected with polarization dependent gain.

In the second mechanism, a cavity with birefringent properties can exhibit a confinement factor that is dependent on the polarization direction. Polarization along the fast axis tends to be less confined compared to the polarization along the slow axis. In a VCSEL, the lateral gain profile is not constant across the aperture due to current crowding and spatial hole burning. Thus, the polarization perpendicular to the grating, which is slightly less confined, receives more gain and is promoted.

In the third mechanism, linear grating couples the light from the vertical direction to the lateral direction. The coupling efficiency is polarization dependent and the polarization parallel to the grating ridge direction is more likely to be coupled. This results in extra cavity losses for the parallel polarization. The perpendicular polarization is thus promoted. This mechanism has the advantage of not being dependent on the gain curve. Accordingly, this third mechanism uses polarization dependent optical losses.

Polarization control with anisotropic patterning of the cavity can be combined with different fabrication methods to define the electrical and optical aperture of the VCSEL. The VCSEL aperture can be defined via oxidation, implantation or lithographically. Lithographic aperture VCSEL can implement subsequent etching and overgrowth of a tunnel junction or a blocking layer.

FIGs. 5A and 5B present two configurations of the patterned cavity with oxide aperture. For both configurations, the fabrication starts with the formation of an epitaxial structure with a patterned cavity as presented in paragraph 23. The epitaxial structure contains a high aluminum concentration layer. During the oxidation of the structure, this layer gets oxidized at a larger rate as compared to the rest of the structure. The unoxidized portion of the layer forms an aperture confining the flow of the operating current and the laser beam.

FIG. 5A illustrates an example of oxide aperture VCSEL with a patterned cavity where the oxide aperture is above the patterned growth interface, in accordance with various example implementations of this disclosure. In FIG. 5A, the oxidation layer forming the aperture is located above the patterned growth interface.

FIG. 5B illustrates an example of oxide aperture VCSEL with a patterned cavity where the oxide aperture is below the patterned growth interface, in accordance with various example implementations of this disclosure. In FIG. 5B, the oxidation layer is located below the patterned growth interface and is part of the bottom epitaxial structure.

FIGs. 6A and 6B present how to combine a patterned VCSEL cavity with a tunnel junction lithographic aperture. Subsequent etch and overgrowth steps enable the insertion of a buried tunnel junction on specific areas. The lithographically defined areas with tunnel junction are significantly more conductive than the areas without tunnel junction which allows lateral electrical confinement and defines the VCSEL aperture. Two process flows are possible to introduce the anisotropic patterning of the cavity.

FIG. 6A illustrates an example of a combining patterned cavity with tunnel junction lithographic aperture with two separated etch and overgrowth steps, in accordance with various example implementations of this disclosure. In the process flow presented in FIG. 6A, the aperture definition and the grating patterning are done in separated etching and growth steps. It starts with the growth of the bottom epitaxial structure comprising the bottom DBR and the active region and terminating with the tunnel junction layers. After the first etch step, the remaining portion of the tunnel junction defines the aperture. A spacer layer is overgrown. Gratings for polarization control are patterned in the spacer layer. Finally, the top epitaxial structure, comprising the top DBR, is overgrown.

FIG. 6B illustrates an example of a combining patterned cavity with tunnel junction lithographic aperture with two successive etch steps and one overgrowth step, in accordance with various example implementations of this disclosure. In the second process flow presented in FIG. 6B, the aperture and the grating are defined within two successive etch steps and one overgrowth. It allows to reduce the number of overgrowths from two to one. In this case, the bottom epitaxial structure terminates with the tunnel junction layers and the spacer layer. A first etch defined the aperture down to the bottom of the tunnel junction. Then, a shallower etch defines the grating for polarization control. Finally, the top epitaxial structure is overgrown.

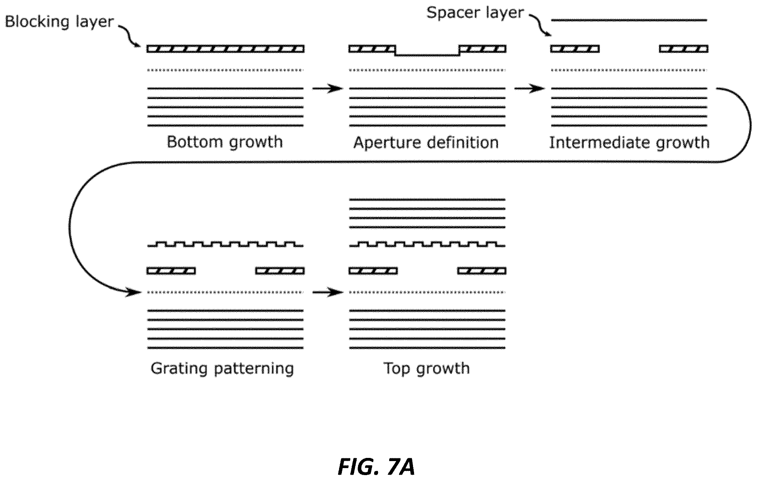

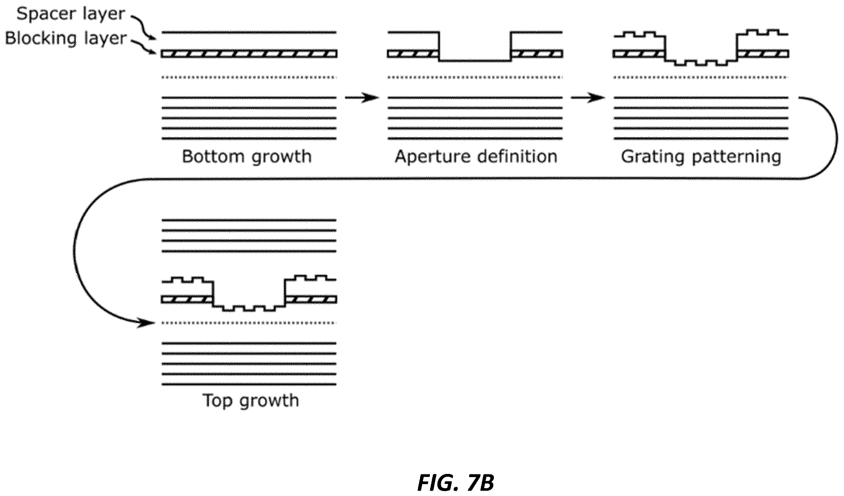

FIGs. 7A and 7B present how to introduce a patterned VCSEL cavity with a blocking layer lithographic aperture. Subsequent etch and overgrowth steps enable the insertion of a blocking layer on specific areas within the epitaxial structure. The lithographically defined areas with blocking layer are significantly more resistive than the areas without blocking layer which allows lateral electrical confinement and defines the VCSEL aperture. Two process flows are possible to introduce the anisotropic patterning of the cavity.

FIG. 7A illustrates an example of a combining patterned cavity with blocking layer lithographic aperture with two separated etch and overgrowth steps, in accordance with various example implementations of this disclosure. In the process flow presented in FIG. 7A, the aperture definition and the grating patterning are done in separated etching and growth steps. It starts with the growth of the bottom epitaxial structure comprising the bottom DBR and the active region and terminating with the blocking layer. A first etch step of the blocking layer defines the aperture. A spacer layer is overgrown. Gratings for polarization control are patterned in the spacer layer. Finally, the top epitaxial structure, comprising the top DBR, is overgrown.

FIG. 7B illustrates an example of a combining patterned cavity with blocking lithographic aperture with two successive etch steps and one overgrowth step, in accordance with various example implementations of this disclosure. In the second process flow presented in FIG. 7B, the aperture and the grating are defined within two successive etch steps and one overgrowth. It allows to reduce the number of overgrowths from two to one. In this case, the bottom epitaxial structure terminates with the blocking layer and the spacer layer. A first etch defined the aperture down to the bottom of the blocking layer. Then, a shallower etch defines the grating. Finally, the top epitaxial structure is overgrown.

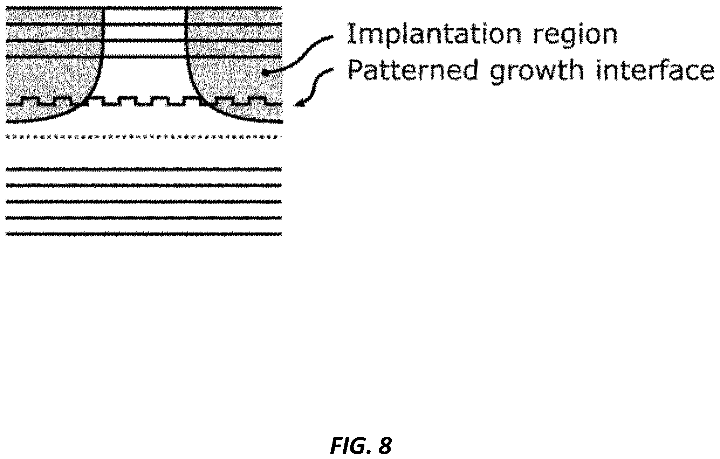

Figure 8 illustrates an example of a combining patterned cavity with an aperture defined with ion implantation. The fabrication starts with the formation of an epitaxial structure with patterned cavity as presented in paragraph 23 (above). In the following step, ion implantation electrically insulates regions of the epitaxial structure. The non-implanted region confines the flow of the operating current and defines the VCSEL aperture.

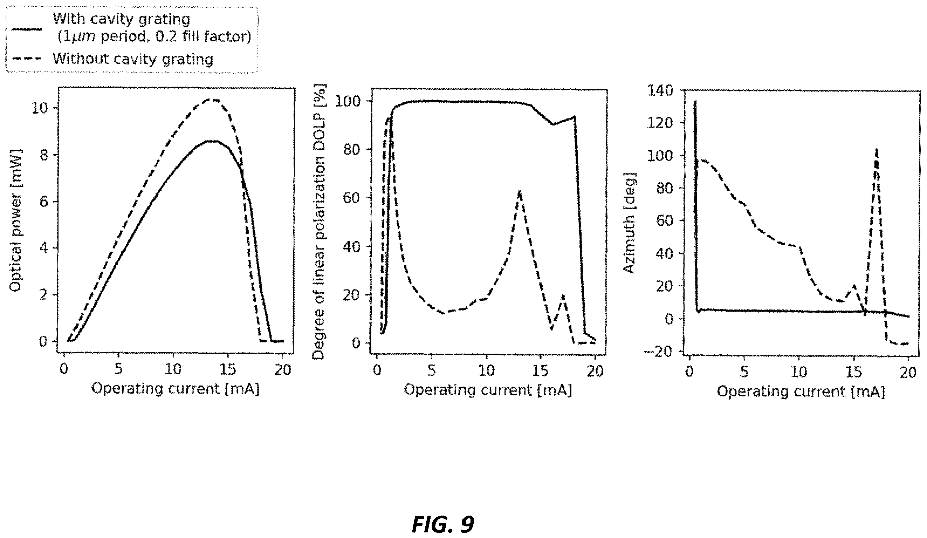

FIG. 9 illustrates an example of power versus current and polarization characteristics, in accordance with various example implementations of this disclosure. The 3 graphs in FIG. 9 represent optical power, DOLP and azimuth.

FIG. 9 shows the impact of the introduction of linear grating in the cavity on the optical vs current and polarization characteristics. In absence of grating, the degree of linear polarization (DOLP) reaches a high value at threshold 95% (polarization extinction ratio (PER) 13dB). This is attributed to the single mode operation. As the operating current increases and higher order modes are emerging, the DOPL decreases significantly, indicating a poor polarization control. In presence of linear grating in the cavity, the DOLP is maintained at >99% (PER >20dB) from the threshold until the device starts rolling over. The azimuth angle measurement shows that the direction of the linear polarization remains perpendicular to the grating direction. This demonstrates the effective linear polarization stability as a result of the linear grating in the cavity.

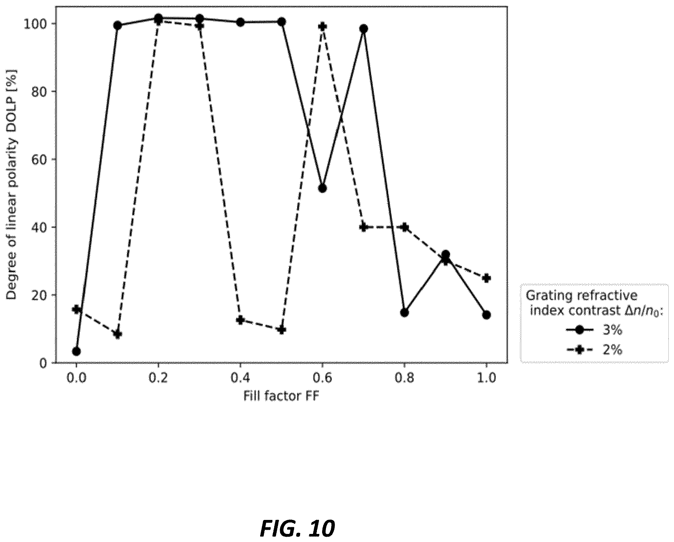

FIG. 10 illustrates an example evolution of the DOLP with the grating fill factor and grating refractive index contrast, in accordance with various example implementations of this disclosure. The grating refractive index contrast is estimated from the emission wavelength difference from the non-etched (FF=1) and fully etched (FF=0) cavity emitters and using the relation:

$$\Delta n / n_0 = \Delta \lambda / \lambda_0$$

Thus, a deeper etch depth results in a greater grating refractive index contrast and consequently a stronger birefringence strength. Effective control of the polarization is demonstrated with a grating refractive index contrast of 2% for grating fill factor of ranging from 0.2 to 0.3. For grating refractive index contrast of 3%, the range of fill factor for stable polarization gets wider from 0.1 to 0.5. As the grating refractive index contrast gets larger, the fabrication tolerance on the grating fill factor is relaxed.

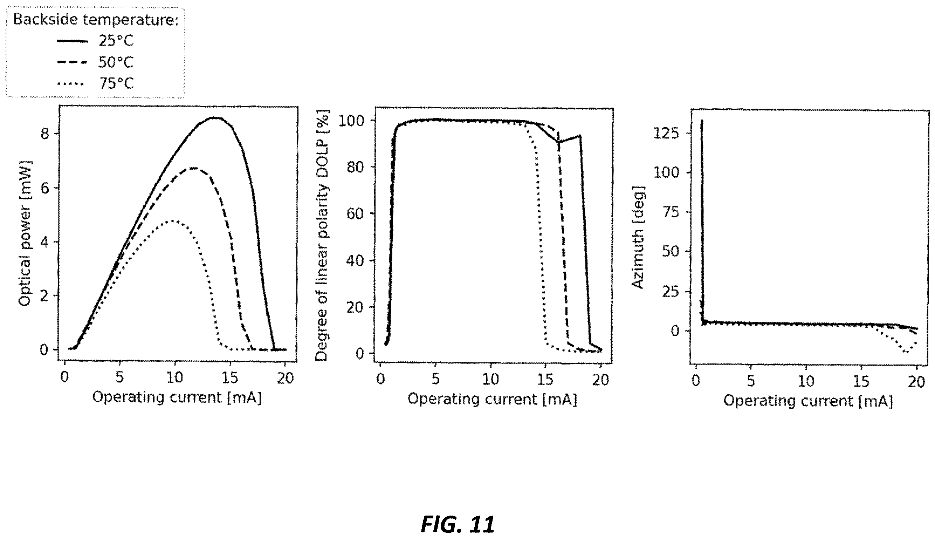

FIG. 11 illustrates an example of optical power and polarization characteristic versus the operating current, in accordance with various example implementations of this disclosure. The 3 graphs in FIG. 11 represent optical power, DOLP and azimuth. FIG. 11 shows the evolution of the optical power and the polarization characteristic vs the operating current under a backside temperature ranging from 25°C to 75°C for a VCSEL device with grating. The polarization remains stable in terms of strength (DOLP>99%, PER>20dB) and direction (perpendicular to the grating) over entire operating range studied. This demonstrates the robustness of the polarization control with cavity patterning. The example device reference in FIG. 11 is a $6\mu m$ diameter VCSEL with a cavity grating having a $1\mu m$ period and a fill factor of 0.2.

In the following, a set of aspects is disclosed. The aspects are numbered to facilitate referencing the features of one aspect in other aspects. The aspects form part of the disclosure of the present application and could be made subject to independent and/or dependent claims irrespective of what currently is claimed in the application. The aspects are:

1. A method of forming a laser structure, the method comprising:

growing a bottom distributed Bragg reflector (DBR) and a first part of a cavity on a substrate to form a bottom structure comprising a plurality of layers;
etching one or more features on an upper layer of the bottom structure to produce a patterned growth interface;
overgrowing a remaining part of the cavity and a top DBR on the patterned growth interface to form an epitaxial structure; and
forming one or more apertures in the epitaxial structure.

2. The method of aspect 1, wherein the first part of the cavity comprises a plurality of active region quantum wells.

3. The method of aspect 1, wherein the etching is one of dry etching and wet etching.

4. The method of aspect 1, wherein the one or more features are subwavelength features defined via lithography.

5. The method of aspect 1, wherein the one or more features are linear gratings.

6. The method of aspect 1, wherein the overgrowing produces a layer having a different material refractive index than the etched layer of the bottom structure.

7. The method of aspect 1, wherein the one or more features are transferred to a profile of the top DBR.

8. The method of aspect 1, wherein the method comprises controlling a birefringence strength according to a selection of one or more features.

9. The method of aspect 1, wherein:

the one or more features comprise a grating that is characterized by a grating ridge width and a grating period, and
the method comprises controlling a birefringence strength according to a ratio of the grating ridge width and the grating period.

10. The method of aspect 1, wherein the forming one or more apertures comprises growing an oxidation layer above the patterned growth interface as part of a top growth of the epitaxial structure.

11. The method of aspect 1, wherein the forming one or more apertures comprises growing an oxidation layer below the patterned growth interface as part of the bottom structure of the epitaxial structure.

12. The method of aspect 1, wherein the method comprises introducing a patterned vertical-cavity surface-emitting laser (VCSEL) cavity with a tunnel junction lithographic aperture.

13. A method of forming a laser structure, the method comprising:

growing a bottom distributed Bragg reflector (DBR) and a first part of a cavity on a substrate to form a bottom structure comprising a plurality of layers;
generating a lithographic aperture on the bottom structure;
overgrowing a spacer layer on the lithographic aperture;
etching one or more features in the spacer layer to form a patterned growth interface; and
overgrowing a top DBR on the patterned growth interface to form an epitaxial structure.

14. The method of aspect 13, wherein the lithographic aperture is a tunnel junction.

15. The method of aspect 13, wherein the method comprises controlling a birefringence strength according to a selection of one or more features.

16. The method of aspect 13, wherein:

the one or more features comprise a grating that is characterized by a grating ridge width and a grating period, and
the method comprises controlling a birefringence strength according to a ratio of the grating ridge width and the grating period.

17. A method of forming a laser structure, the method comprising:

growing a bottom distributed Bragg reflector (DBR) and a first part of a cavity on a substrate to form a bottom structure comprising a plurality of layers;
generating a lithographic aperture on the bottom structure;
growing a spacer layer on the lithographic aperture;
defining the lithographic aperture via etching through the spacer layer;
etching one or more features in the spacer layer to form a patterned growth interface; and
overgrowing a top DBR on the patterned growth interface to form an epitaxial structure.

18. The method of aspect 17, wherein the method comprises controlling a birefringence strength according to a selection of one or more features.

19. The method of aspect 17, wherein:

the one or more features comprise a grating that is characterized by a grating ridge width and a grating period, and

the method comprises controlling a birefringence strength according to a ratio of the grating ridge width and the grating period.

20. The method of aspect 17, wherein the lithographic aperture is a tunnel junction.

21. The method of aspect 1, wherein the bottom DBR has a lower reflectivity compared to the top DBR, thereby enabling a bottom emission configuration.

22. The method of aspect 13, wherein the bottom DBR has a lower reflectivity compared to the top DBR, thereby enabling a bottom emission configuration.

23. The method of aspect 17, wherein the bottom DBR has a lower reflectivity compared to the top DBR, thereby enabling a bottom emission configuration.

24. The method of aspect 1, wherein the one or more features are anisotropic features.

25. The method of aspect 13, wherein the one or more features are anisotropic features.

26. The method of aspect 17, wherein the one or more features are anisotropic features.

27. The method of aspect 1, wherein the one or more apertures comprises implantation.

28. The method of aspect 1, wherein the one or more apertures comprise a blocking layer lithographic aperture.

29. The method of aspect 1, wherein the remaining part of the cavity comprises a plurality of active region quantum wells.

Implementations as described herein may relate to the following: A method of forming a VCSEL with a structural birefringent cavity. This method may comprise growing a bottom distributed Bragg reflector (DBR) and a first part of a cavity on a substrate to form a bottom structure comprising a plurality of layers. One or more anisotropic features may be etched on a upper layer of the bottom structure to produce a patterned growth interface. A remaining part of the cavity and a top DBR on the patterned growth interface may be overgrown to form an epitaxial structure. One or more oxide apertures may be formed in the epitaxial structure.

The present application claims priority of U.S. Provisional Patent Application No. 63/417,626, filed October 19, 2022, and U.S. Patent Application No. 18/312,967, filed May 5, 2023. The entire disclosure of these applications is hereby explicitly incorporated by reference into the present application.

While the present method and/or system has been described with reference to certain implementations, it will be understood by those skilled in the art that various changes may be made and equivalents may be substituted without departing from the scope of the present method and/or system. In addition, many modifications may be made to adapt a particular situation or material to the teachings of the present disclosure without departing from its scope. Therefore, it is intended that the present method and/or system not be limited to the particular implementations disclosed, but that the present method and/or system will include all implementations falling within the scope of the appended claims.

**Claims**

1. A method of forming a laser structure, the method comprising:

   growing a bottom distributed Bragg reflector (DBR) and a first part of a cavity on a substrate to form a bottom structure comprising a plurality of layers;
   etching one or more features on an upper layer of the bottom structure to produce a patterned growth interface;
   overgrowing a remaining part of the cavity and a top DBR on the patterned growth interface to form an epitaxial structure; and
   forming one or more apertures in the epitaxial structure.

2. The method of claim 1, wherein the first part of the cavity comprises a plurality of active region quantum wells, and/or
wherein the remaining part of the cavity comprises a plurality of active region quantum wells.

3. The method of claim 1 or 2, wherein the etching is one of dry etching and wet etching, and/or
wherein the overgrowing produces a layer having a different material refractive index than the etched layer of the bottom structure.

4. The method of any one of claims 1 to 3, wherein the one or more features are subwavelength features defined via lithography, and/or
wherein the one or more features are linear gratings.

5. The method of any one of claims 1 to 4, wherein the one or more features are transferred to a profile of the top DBR, and/or
wherein the bottom DBR has a lower reflectivity compared to the top DBR, thereby enabling a bottom emission configuration.

6. The method of any one of claims 1 to 5, wherein the method comprises controlling a birefringence strength according to a selection of one or more features, and/or
wherein the one or more features are anisotropic features.

7. The method of any one of claims 1 to 6, wherein:

the one or more features comprise a grating that is **characterized by** a grating ridge width and a grating period, and
the method comprises controlling a birefringence strength according to a ratio of the grating ridge width and the grating period.

8. The method of any one of claims 1 to 7, wherein the forming one or more apertures comprises growing an oxidation layer above the patterned growth interface as part of a top growth of the epitaxial structure, and/or

wherein the forming one or more apertures comprises growing an oxidation layer below the patterned growth interface as part of the bottom structure of the epitaxial structure, and/or
wherein the one or more apertures comprise implantation and/or
wherein the one or more apertures comprise a blocking layer lithographic aperture.

9. The method of any one of claims 1 to 8, wherein the method comprises introducing a patterned vertical-cavity surface-emitting laser (VCSEL) cavity with a tunnel junction lithographic aperture.

10. A method of forming a laser structure, the method comprising:

growing a bottom distributed Bragg reflector (DBR) and a first part of a cavity on a substrate to form a bottom structure comprising a plurality of layers;
generating a lithographic aperture on the bottom structure;
overgrowing a spacer layer on the lithographic aperture;
etching one or more features in the spacer layer to form a patterned growth interface; and
overgrowing a top DBR on the patterned growth interface to form an epitaxial structure.

11. The method of claim 10, wherein the lithographic aperture is a tunnel junction, and/or

wherein the bottom DBR has a lower reflectivity compared to the top DBR, thereby enabling a bottom emission configuration, and/or

wherein the method comprises controlling a birefringence strength according to a selection of one or more features, and/or
wherein the one or more features are anisotropic features.

12. The method of claim 10 or 11, wherein:

the one or more features comprise a grating that is **characterized by** a grating ridge width and a grating period, and
the method comprises controlling a birefringence strength according to a ratio of the grating ridge width and the grating period.

13. A method of forming a laser structure, the method comprising:

growing a bottom distributed Bragg reflector (DBR) and a first part of a cavity on a substrate to form a bottom structure comprising a plurality of layers;
generating a lithographic aperture on the bottom structure;
growing a spacer layer on the lithographic aperture;
defining the lithographic aperture via etching through the spacer layer;
etching one or more features in the spacer layer to form a patterned growth interface; and
overgrowing a top DBR on the patterned growth interface to form an epitaxial structure.

14. The method of claim 13, wherein the lithographic aperture is a tunnel junction, and/or

wherein the bottom DBR has a lower reflectivity compared to the top DBR, thereby enabling a bottom emission configuration, and/or
wherein the method comprises controlling a birefringence strength according to a selection of one or more features, and/or
wherein the one or more features are anisotropic features.

15. The method of claim 13 or 14, wherein:

the one or more features comprise a grating that is **characterized by** a grating ridge width and a grating period, and
the method comprises controlling a birefringence strength according to a ratio of the grating ridge width and the grating period.

Anisotropic features 104

Active region QWs 103

Top DBR 107
Top cavity 105b

$n_\perp$  $n_\parallel$

Bottom cavity 105a
Bottom DBR 101

| 1) Bottom structure growth 101/105a/103 | 2) Cavity anisotropic patterning 104 | 3) Top structure growth 105b/107 |

*FIG. 1*

Reflector 1

$n_1$  $n_0$

Reflector 2

*FIG. 2A*

Reflector 1

$n_0$

Reflector 2

*FIG. 2B*

**FIG. 3A**

**FIG. 3B**

**FIG. 4A**

**FIG. 4B**

EP 4 358 325 A1

Oxide aperture
Patterned growth interface

**FIG. 5A**

Patterned growth interface
Oxide aperture

**FIG. 5B**

Tunnel junction

Spacer layer

Bottom growth

Aperture definition

Intermediate growth

Grating patterning

Top growth

FIG. 6A

EP 4 358 325 A1

Spacer layer
Tunnel junction

Bottom growth → Aperture definition → Grating patterning

Top growth

*FIG. 6B*

Blocking layer

Spacer layer

Bottom growth

Aperture definition

Intermediate growth

Grating patterning

Top growth

**FIG. 7A**

EP 4 358 325 A1

Spacer layer
Blocking layer

Bottom growth

Aperture definition

Grating patterning

Top growth

*FIG. 7B*

Implantation region
Patterned growth interface

FIG. 8

*FIG. 9*

**FIG. 10**

**FIG. 11**

EP 4 358 325 A1

Europäisches
Patentamt

European
Patent Office

Office européen
des brevets

## EUROPEAN SEARCH REPORT

Application Number

EP 23 19 8235

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | US 2022/158417 A1 (PISSIS ANTOINE PHILIPPE [CH] ET AL) 19 May 2022 (2022-05-19)<br>* paragraph [0038] - paragraph [0066]; figures 1-4,5A-5C * | 1-4,6-9<br><br>5<br>13-15 | INV.<br>H01S5/183<br>H01S5/30<br>H01S5/20 |
| X<br>Y<br>A | US 2022/209503 A1 (BERK YURI [IL] ET AL) 30 June 2022 (2022-06-30)<br>* paragraph [0080] - paragraph [0085]; figure 5 * | 1,2,4,6,7,9<br>5<br>13-15 | |
| X<br>Y<br>A | US 2010/128749 A1 (AMANN MARKUS-CHRISTIAN [DE] ET AL) 27 May 2010 (2010-05-27)<br>* paragraph [0016] *<br>* paragraph [0034] - paragraph [0044]; figures 1-3D * | 10-12<br><br>5<br>13-15 | |
| A | US 2003/048827 A1 (HWANG WEN-YEN [US] ET AL) 13 March 2003 (2003-03-13)<br>* paragraph [0035] - paragraph [0039]; figures 3-5 * | 1-15 | |
| A | ORTSIEFER M ET AL: "Polarization Control in Buried Tunnel Junction VCSELs Using a Birefringent Semiconductor/Dielectric Subwavelength Grating",<br>IEEE PHOTONICS TECHNOLOGY LETTERS, IEEE, USA,<br>vol. 21, no. 1,<br>1 January 2010 (2010-01-01), pages 15-17, XP011283882,<br>ISSN: 1041-1135<br>* page 15 - page 16; figure 1 * | 1-15 | **TECHNICAL FIELDS SEARCHED (IPC)**<br><br>H01S |

The present search report has been drawn up for all claims

| Place of search | Date of completion of the search | Examiner |
|---|---|---|
| Munich | 11 March 2024 | Hervé, Denis |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 358 325 A1**

## ANNEX TO THE EUROPEAN SEARCH REPORT
## ON EUROPEAN PATENT APPLICATION NO.

EP 23 19 8235

This annex lists the patent family members relating to the patent documents cited in the above-mentioned European search report.
The members are as contained in the European Patent Office EDP file on
The European Patent Office is in no way liable for these particulars which are merely given for the purpose of information.

11-03-2024

| Patent document cited in search report | | Publication date | Patent family member(s) | | Publication date |
|---|---|---|---|---|---|
| US 2022158417 | A1 | 19-05-2022 | CN | 114498298 A | 13-05-2022 |
| | | | TW | 202236763 A | 16-09-2022 |
| | | | US | 2022158417 A1 | 19-05-2022 |
| US 2022209503 | A1 | 30-06-2022 | CN | 114825040 A | 29-07-2022 |
| | | | DE | 102021214910 A1 | 30-06-2022 |
| | | | GB | 2603639 A | 10-08-2022 |
| | | | US | 2022209503 A1 | 30-06-2022 |
| US 2010128749 | A1 | 27-05-2010 | DE | 102009001505 A1 | 27-05-2010 |
| | | | EP | 2190082 A2 | 26-05-2010 |
| | | | US | 2010128749 A1 | 27-05-2010 |
| US 2003048827 | A1 | 13-03-2003 | NONE | | |

EPO FORM P0459

For more details about this annex : see Official Journal of the European Patent Office, No. 12/82

23

**EP 4 358 325 A1**

## REFERENCES CITED IN THE DESCRIPTION

**Patent documents cited in the description**

- US 63417626
- US 31296723